## Europäisches Patentamt

## European Patent Office

## Office européen des brevets

(19)

(11) Veröffentlichungsnummer: **0 247 635**
A2

## EUROPÄISCHE PATENTANMELDUNG

(12)

(21) Anmeldenummer: **87107862.2**

(22) Anmeldetag: **30.05.87**

(51) Int. Cl.⁴: **H 01 C 1/082, H 01 L 23/46**

(30) Priorität: **30.05.86 IT 2204086 U**

(43) Veröffentlichungstag der Anmeldung: **02.12.87**
Patentblatt 87/49

(84) Benannte Vertragsstaaten: **CH DE FR GB IT LI NL SE**

(71) Anmelder: **Tecnomasio Italiano Brown Boveri S.p.A.,
P.lc. Lodi, 3, I-20137 Mailand (IT)**

(72) Erfinder: **Scovenna, Domenico, Viale Brenta 7,
I-20139 Milano (IT)**

(74) Vertreter: **Mayer, Hans Benno, Via dell'Orso 7/A,
I-20121 Milano (IT)**

(54) **Verzehrwiderstand mit Zwangsluftkühlung für elektronische Umrichter, besonders für eine elektrische Antriebsvorrichtung.**

(57) Die vorstehende Erfindung betrifft einen Verzehrwiderstand mit Zwangsluftkühlung, für elektronische Umrichter, besonders für eine elektrische Antriebsvorrichtung. Der Erfindungsgegenstand weist den Vorteil auf, dass mindestens ein Widerstand vorgesehen ist, der im wesentlichen zylinderförmige Gestalt hat, und im Inneren eines zylinderförmigen Gehäuses untergebracht ist und mit dem Widerstand einen ringförmigen Spalt bildet, der an seinen Enden offen gelassen ist, um die Zuführung eines Kühlluftstromes, der den Widerstand umstreicht, zu ermöglichen.

In vorteilhafter Weise sind am Eintritt des Kühlluftstromes Regeleinrichtungen zum Verändern der Luftströmungsmenge vorgesehen.

ACTORUM AG

- 1 -

Akte 03-443

Tecnomasio Italiano Brown, Boveri S.p.A.

Milano (Italien)


"Verzehrwiderstand mit Zwangsluftkuehlung fuer elektronische Umrichter, besonders fuer eine elektrische Antriebsvorrichtung"


Die vorstehende Erfindung betrifft einen Verzehrwiderstand mit Zwangsluftkuehlung fuer elektronische Umrichter, besonders fuer elektrische Antriebsvorrichtungen.

Wie bekannt ist, sind fuer Umrichter in Halbleiterbauart, besonders auf dem Gebiete der Leistungselektronik, Daempfungselemente vorzusehen, die allgemein aus Widerstaenden oder Kondensatoren bestehen, die miteinander in Serie geschaltet sind und an die Pole der Halbleiter angeschlossen sind.

Bei hoher Umschaltleistung und/oder Umschaltfrequenz, besonders fuer den Fall bei dem durch die Widerstaende sehr hohe Leistungen aufzuzehren sind, die in der Groessenordnung einiger 100 Watt liegen, ist es erforderlich, eine wirkungsvoll Kuehlung zu gewaehrleisten .

Mit den aus dem Stand der Technik her bekannten Loesungen sind bei den Umrichtern in Halbleiternbauweise, besonders bei Umrichtern die in der elektrischen Antriebstechnik Verwendung finden, Ventilatoren eingesetzt, die einen Kuehlluftstrom erzeugen. Solche Ventilatore weisen erhebliche Groesse und ein betraechtliches

- 2 -

Baugewicht auf. Dies ist nachteilig in Hinblick auf wirtschaftlichen Einsatz.

Ein weiterer Nachteil fuer derartige Einrichtungen besteht darin, dass fuer die notwendige Aufzehrung der Waermeenergie erhebliche Leistungen aufzubringen sind, diese grosse Leistungsaufnahme wirkt sich aber nachteilig auf die Steuerung des elektronischen Umrichters fuer elektrische Antriebsvorrichtungen aus.

Aufgabe der vorstehenden Erfindung ist es, die angefuehrten Nachteile des Standes der Technik zu vermeiden und einen Verzehrwiderstand mit Zwangsluftkuehlung vorzuschlagen, der die Moeglichkeit schafft, die erforderliche Kuehlluftmenge auf ein Minimum zu reduzieren aber gleichzeitig einen optimalen Waermeaustausch bei der Kuehlung des Widerstandes zu erzielen.

Eine weitere Aufgabe der Erfindung besteht darin, einen Verzehrwiderstand vorzuschlagen, der die Moeglichkeit eroeffnet, die notwendige Kuehlluftmenge auf ein Minimum zu reduzieren und den Druckabfall im Kuehlluftstrom gleich gross zu halten wie bei den Kuehllamellen der Halbleiter.

Eine weitere Aufgabe der Erfindung besteht darin, einen Verzehrwiderstand zu schaffen, der aufgrund seiner neuen Bauweise geeignet ist, groesstmoegliche Betriebsicherheit zu gewaehrleisten.

Eine weitere Aufgabe der vorstehenden Erfindung ist darin zu sehen, einen Verzehrwiderstand mit Zwangsluftkuehlung vorzuschlagen, der besonders fuer elektronische Umrichter in elektrischen Zugeinrichtungen einsetzbar ist, der einfach herstellbar ist, unter Verwendung von Bauteilen und Materialien, die einfach auf dem Markt auffindbar sind und damit auch Vorteile in wirtschaflticher Hinsicht bringt.

Die genannten Aufgaben werden mit einem Verzehrwiderstand geloest, der mit Mitteln zur Zwangsluftkuehlung versehen ist, besonders fuer elektronische Umrichter fuer elektrische Zugeinrichtungen, und der sich dadurch kennzeichnet, dass wenigstens ein zylinderfoermiger Widerstand vorgesehen ist, dass dieser im Inneren eines zylinderfoermigen Gehaeuses angeordnet ist, das zusammen mit mindestens einem Widerstand eine ringfoermige Kammer bildet, die an ihren Enden offen ist und einen Kuehlluftstrom um den und laengs zum Widerstand fuehrt.

Weitere Vorteile und Merkmale der Erfindung koennen der nun folgenden Beschreibung eines Ausfuehrungsbeispieles eines Verzehrwiderstandes mit Zwangsluftkuehlung, hauptsaechlich fuer elektronische Umrichter fuer elektrische Zugeinrichtungen entnommen werden, der anhand eines Beipieles in den Zeichnungen dargestellt ist.

Es zeigen:

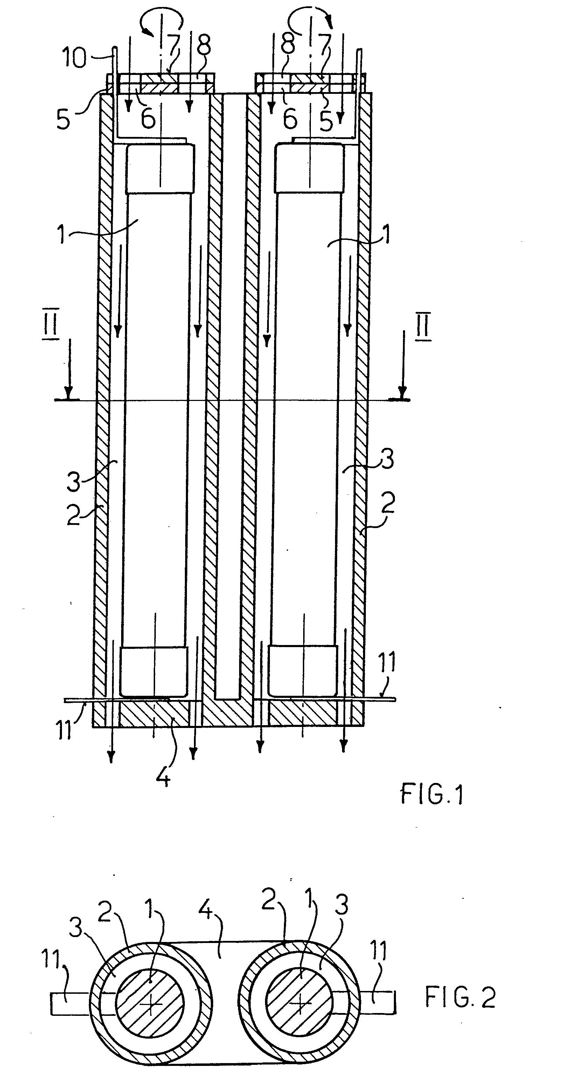

Fig. 1 eine moegliche Ausfuehrungsform des Verzehrwiderstandes im Laengsschnitt;

Fig. 2 einen Schnitt entlang der Linie II-II der Fig. 1.

Aus den Zeichnungen wird ersichtlich, dass der dargestellt Versehrwiderstand aus zwei Widerstandselemente besteht, die mit dem Bezugszeichen 1 gekennzeichnet sind und im wesentlichen laengliche, zylindrische Form aufweisen. Selbstverstaendlich kann die Anzahl der Widerstaende beliebig gewaehlt sein. Es tritt keine Aenderung des Grundgedankens zu vorstehender Erfindung ein.

Jeder Widerstand 1 ist im Inneren eines zylinderfoermigen Gehaeuses 2 untergebracht, in vorteilhafter Weise decken sich die Laengsachsen von Widerstand 1 und Gehaeuse 2.

Das zylinderfoermige Gehaeuse 2 und der Widerstand 1 bilden zusammen einen Ringspalt 3, der an seinen Enden offen ist. Der Ringspalt 3 umhuellt die Aussenflaeche des Widerstandes 1 und bildet einen gleichmaessigen Kanal fuer den Durchfluss des zur Zwangsluftkuehlung notwendigen Luftstromes. Der Luftstrom durchfliesst den Ringkanal 3 in Laengsrichtung und bestreicht dadurch die aeusseren Wandteile des Widerstandes mit entsprechender Waermeabfuhr.

Die Verwendung eines Spaltes mit gleichmaessiger Form und Abmessung gibt die Moeglichkeit, die Waermeabfuhr gleichmaessiger zu gestalten, auch wenn eine geringe Luftmenge zugefuehrt wird, denn es wird jegliche Umleitung des Luftstromes vermieden und eventuelle Stroemungswiderstaende treten einer wirksamen Stroemung des Kuehlungsstromes nicht entgegen.

Entsprechend einer bevorzugten Ausfuehrungsform, die jedoch nicht bindend ist, ist das zylinderfoermige Gehaeuse 2 Bestandteil ener Aufnahme- und Haltevorrichtung 4 des Widerstandes 1. In diesem Falle ist das Gehaeuse 2 aus isolierendem Material hergestellt, z.B. aus dem Material, das durch Verpressen schon fuer die Herstellung der Lagervorrichtung des Widerstandes Verwendung findet.

An der Einlaufseite des Kuehlluftstromes sind Regeleinrichtungen vorgesehen, mit denen die Luftmenge des zugefuehrten Kuehlfluftstromes regelbar ist, um somit den Kuehlluftstrom an die Waermeverluste eines jeden Widerstandselementes anzupassen.

Entsprechend einer bevorzugten Ausfuehrungsform, die jedoch nicht bindend ist, bestehen die Regeleinrichtungen fuer den zugefuehrten Kuehlluftstrom aus einer feststehenden Blende 5, die mit Bohrungen 6 versehen ist; ferner ist eine verdrehbare Blende 7 vorgesehen, die mit verschiebbaren Oefffnungen 8 versehen ist, die teilweise oder vollstaendig mit den Oeffnungen 6 zur Deckung gebracht werden koennen, um somit die Zuflussmenge des Kuehlluftstromes zu regeln.

Wie in den Zeichnungen dargestellt ist, treten die Verbindungskontakte des Widerstandes 1, Kontakte die mit 10 gekennzeichnet sind, an den Enden des zylinderfoermigen Gehaeuses 2 aus diesem aus. Dadruch wird ein einfaches Anbringen der Leitungen aussen am Gehaeuse moeglich.

Im praktische Gebrauch tritt ein, dass der erfindungsgemaesse Verzehrwiderstand von einem Spalt umgeben ist, der in der Praxis die Durchflusskammer fuer den Luftstrom zur Zwangskuehlung des Widerstandes ermoeglicht. Der Luftstrom umstroemt gleichmaessig den Widerstand, dies mit einem verhaeltnismaessig bescheidenen Luftvolumen. Dadurch wird die Moeglichkeit geschaffen, geringe Foerdermengen fuer den Kuehlluftstrom vorzusehen. Gleichzeitig ergibt sich ein maximaler Waermeaustausch zwischen Widerstand und Luftstrom, um somit die gewuenschte Kuehlwirkung zu erreichen. Die Moeglichkeit, eine verminderte Luftmenge einzusetzen, bringt wesentliche Vorteile mit sich, einmal was die Auslegung der Luefterblaetter zur Erzeugung des Kuehlluftstromes anbetrifft, ferner was den Platzbedarfes und das Gewichtes der verwendeten Luefters anbelangt.

Ein weiterer, wichtiger Gesichtspunkt der Erfindung besteht darin, dass ein Verzehrwiderstand in sehr kompakter Bauweise geschaffen wird, in welchem das zylinderfoermige Gehaeuse nicht nur als Fuehrung fuer den Kuehlluftstrom, sondern gleichzeitig als Schutzgehaeuse fuer den Widerstand dient.

Ferner wird durch die Moeglichkeit, die Kuehlluftmenge zu regelen und an jeden elektrischen Widerstand anzupassen, die Moeglichkeit geschaffen, den Leistungsgrad zu optimieren und stets einen dosierten Luftstrom, entsprechend der abzuleitenden Waermemenge, zuzufuehren.

Aus der vorangegangenen Darstellung kann entnommen werden, wie in einfacher Weise die erfindungsgemaessen Aufgaben geloest werden koennen. Es sei an dieser Stelle noch auf den einfachen Aufbau der Vorrichtung hingewiesen, Aufbau der wesentliche funktionelle und bauliche Vorteile mit sich bringt.

Die erfindungsgemaesse Vorrichtung kann nach Belieben baulichen Aenderungen unterworfen werden, die jedoch alle in den Schutzumfang der Erfindung fallen.

Ferner besteht die Moeglichkeit, dass alle dargestellten Bauteile durch technisch gleichwertige Mittel ersetzt werden koennen.

Besonders koennen die verwendeten Materialien, sofern diese mit dem Verwendungszweck der Vorrichtung in Einlang stehen, die Abmessungen, sowie die Bauform abgeaendert und besonderern Beduerfnissen angepasst werden.

**Patentansprueche**

1. Verzehrwiderstand mit Zwangsluftkuehlung, fuer elektronische Umrichter, besonders fuer elektrische Antriebseinrichtungen, **dadurch gekennzeichnet**, dass mindestens ein zylinderfoermiger Widerstand (1) vorgesehen ist, dass dieser im Inneren (3) eines zylinderfoermigen Gehaeuses (2) angeordnet ist, das zusammen mit wenigstens einem Widerstand (1) eine ringfoermige Kammer (3) bildet, die an ihren Enden (4,7) offen ist und einen Kuehlluftstrom um und laengs zum Widerstand zu fuehren.

2. Verzehrwiderstand mit Zwangsluftkuehlung, nach Patentanspruch 1, **dadurch gekennzeichnet**, dass an der Eingangsoeffnung des Gehaeuses (2) fuer die Zufuhr des Kuehlluftstromes in den Ringspalt (3) Regeleinrichtung (5,6,7,8) zum Regeln · des Luftstromes vorgesehen sind.

3. Verzehrwiderstand mit Zwangsluftkuehlung, nach Patentanspruch 1, **dadurch gekennzeichnet**, dass das zylinderfoermige Gehaeuse (2) achsgleich zum Widerstand (1) angeordnet ist.

4. Verzehrwiderstand mit Zwangsluftkuehlung, nach einem der Patentansprueche 1 - 3, **dadurch gekennzeichnet**, dass das zylinderfoermige · Gehaeuse (2) Teil der Aufnahme- und Lagervorrichtung des Widerstandes ist.

5. Verzehrwiderstand mit Zwangsluftkuehlung, nach Patentanspruch 1 - 4, **dadurch gekennzeichnet**, dass die Regeleinrichtung (5,6,7,8) fuer den Luftstrom eine festangeordnete Blende (5) aufweist, die mit Bohrungen (6) versehen ist und mit einer beweglich angeordneten

- 9 -

Blende (7), die mit verschiebbaren Bohrungen (8) versehen ist, zusammenwirkt, und dass die fest angeordneten Bohrungen (6) teilweise oder vollstaendig in Deckung mit den beweglichen Bohrungen (8) bringbar sind, um die Menge des zugefuehrten Luftstromes zu regeln.

6. Verzehrwiderstand mit Zwangsluftkuehlung, nach Patentanspruch 1, **dadurch gekennzeichnet**, dass die elektrischen Anschlusspole (10,11) des Widertandes (1) aus dem zylinderfoermigen Gehaeuse (2), an dessen Enden (5,7; 4)austreten.

FIG.1

FIG.2